# EUROPEAN PATENT APPLICATION

(11) **EP 4 327 916 A1**
(43) Date of publication of application: **28.02.2024**
(21) Application number: 22790209.5
(22) Date of filing: 20.04.2022
(51) Int. Cl.: B01D 53/32, H05H 1/34, H01L 21/67

(54) **DEVICE FOR TREATING SEMICONDUCTOR PROCESS EXHAUST GAS**

(30) Priority: 21.04.2021 KR 20210051514
(71) Applicant: Plasma Science System Co., Ltd., Hwaseong-si Gyeonggi-do 18469 (KR)
(72) Inventor: YOON, Jong Pil, Cheonan-si Chungcheongnam-do 31199 (KR)
(74) Representative: Marks & Clerk LLP
(86) International application number: PCT/KR2022/005650
(87) International publication number: WO 2022/225326

(57) **Abstract**

Provided is an exhaust gas treatment apparatus that treats exhaust gas generated from semiconductor process and directed to a vacuum pump. Exhaust gas treatment apparatus includes a plasma generating unit for generating plasma, a reaction chamber in which perfluoride is decomposed by the plasma to generate a decomposition gas, and gas supplying unit for supplying the decomposition gas from the reaction chamber to a processing chamber in which the exhaust gas from the semiconductor process is introduced and treated exhaust gas is discharged to the vacuum pump. Decomposition gas reacts with the exhaust gas in the processing chamber to suppress generation of salt in solid state by a component of the exhaust gas.

## Description

### [Technical Field]

The present invention relates to treatment apparatus of exhaust gas generated at semiconductor process, and more specifically, to exhaust gas treatment apparatus for suppressing generation of solid salt before exhaust gas is expelled to a vacuum pump.

### [Background Art]

As the semiconductor and LCD industries become larger and production increases, the gas used in the process is also increasing. The semiconductor manufacturing process has a number of steps, and the types of gases used therein are as diverse as the number of steps of the process.

For example, in a semiconductor device manufacturing process, processes such as photolithography, etching, diffusion, and metal deposition are repeatedly performed on a wafer supplied to a process chamber. During the semiconductor manufacturing process, various process gases are used, and after the process is completed, the exhaust gas is discharged from the process chamber by a vacuum pump, and since the exhaust gas may contain toxic components, it is purified by treatment apparatus such as a scrubber.

However, power is generated from the exhaust gas of semiconductor process depending on the temperature and pressure conditions. For example, in case of a TiN forming process in which titanium nitride (TiN) is deposited on a wafer by reacting titanium chloride (TiCl₄) gas with ammonia (NH₃) gas using chemical vapor deposition (CVD), the ammonium chloride (NH₄Cl) powder as well as residual TiN powder discharged without being deposited on the wafer is deposited in the exhaust pipe or vacuum pump, and the deposited powder causes various problems.

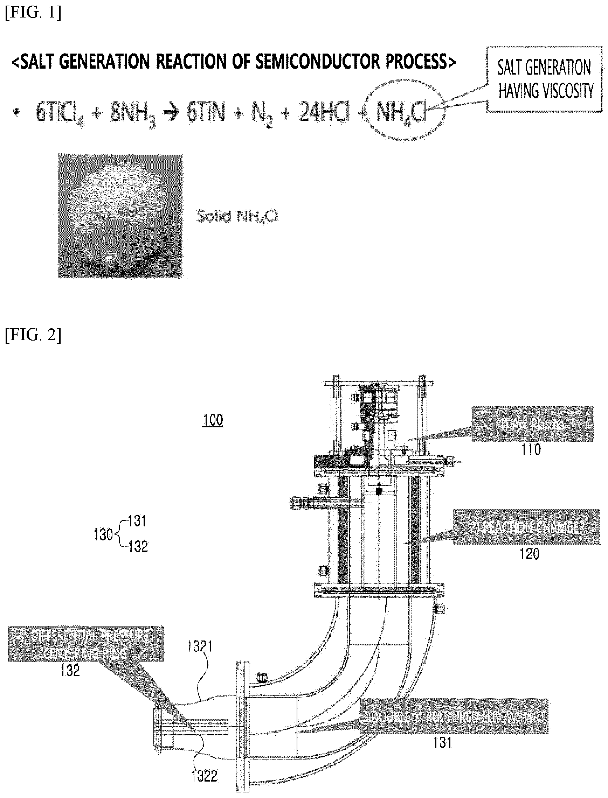

FIG. 1 is view for explaining an example in which salt powder is generated due to exhaust gas in a semiconductor process.

Referring to FIG. 1, NH₄Cl powder is generated by reacting HCl gas and NH₃ gas which is contained in the exhaust gas discharged from TiN processing chamber during TiN process. The NH₄Cl on condition of 160 °C to 170 °C is gas phase at foreline, where the pressure is 1 Torr to 2 Torr. However, the phase of the NH₄Cl is changed to solid phase at 760 Torr and 340 °C.

In order to solve the problem of powder deposition in the exhaust pipe by NH₄Cl, a heater such as a heating jacket is conventionally used. The heater prevents HCl gas from reacting with the NH₃ gas to produce NH₄Cl in a solid state by heating the exhaust pipe to a specific temperature or higher. In addition, NH₄Cl in a solid state is decomposed to HCl gas and NH₃ gas due to the heater, and the decomposed gases pass through the exhaust pipe.

However, this conventional art is difficult to be a fundamental solution to the problem of powder deposition because HCl gas and NH₃ gas can easily react, so that NH₄Cl powder can be easily regenerated.

So, NH₄Cl which is one of by-products in process using TiCl, NH₃ or WF₆, in particular and is formed in a large amount in TiN process of ALD becomes a solid salt, and causes the above-mentioned problem. Due to the deposited solid salt, the number of the vacuum pump malfunction increases and the stop loss increases, so that production and facility operation are difficult. In addition, the cleaning cost due to frequent maintenance increases. Therefore, there is a need for a solution for the stable and economical operation of the vacuum pump.

### [Disclosure]

### [Technical Problem]

A technical object of the present invention is to provide exhaust gas treatment apparatus which is used in semiconductor process, locates in front of the vacuum pump, suppresses the generation of NH₄Cl salt powder through decomposition (generation of F radical) of NF₃ gas, and secures lifetime of plasma electrode compared to the conventional technology.

The technical problems to be achieved by the present invention are not limited to the technical problems mentioned above, and other technical problems not mentioned can be clearly understood by those of ordinary skill in the art to which the present invention belongs by the following description.

### [Technical Solution]

In order to solve the above problem, one embodiment of the present invention provides exhaust gas treatment apparatus for semiconductor process, which performs processing the exhaust gas generated from the semiconductor process and directed to the vacuum pump. The exhaust gas treatment apparatus includes a plasma generating unit for generating plasma; reaction chamber in which perfluoride is decomposed by the plasma to generate a decomposition gas; and a gas supplying unit for supplying the decomposition gas from the reaction chamber to a processing chamber in which the exhaust gas from the semiconductor process is introduced and treated exhaust gas is discharged to the vacuum pump, wherein the decomposition gas reacts with the exhaust gas in the processing chamber to suppress generation of salt in solid state by a component of the exhaust gas.

In an embodiment of the present invention, the plasma generating unit generates N₂ plasma by arc plasma, NF₃ that is the perfluoride supplied to the reaction chamber is decomposed by the N₂ plasma to be formed as the decomposition gas having N₂, NF₃ or F⁻. The decomposition gas supplied to the processing chamber reacts with NH₃ of the exhaust gas or generated NH₄Cl to generate gaseous NH₄F, thereby generation of solid NH₄Cl is suppressed.

In an embodiment of the present invention, the gas supplying unit may include a connection pipe; and a gas injecting unit. The decomposition gas flows the connection pipe from the reaction chamber, and the gas injecting unit is provided between the connection pipe and the processing chamber, and injects the decomposition gas into the processing chamber.

In an embodiment of the present invention, the gas injecting unit may include exterior portion of which one end is coupled to the connection pipe and a differential pressure centering ring. The differential pressure centering ring is provided inside the exterior portion to pass through the other end of the exterior portion and is spaced apart from the inner surface of the exterior portion, and injects the decomposition gas into the processing chamber by a pressure difference between the connection pipe and processing chamber.

In an embodiment of the present invention, the uniformity of the decomposition gas may be improved by vortex due to the space between the differential pressure centering ring and inner surface of the exterior portion, and then the decomposition gas may be introduced into the differential pressure centering ring.

In an embodiment of the present invention, the NF₃ gas is supplied to the reaction chamber instead of between anode and cathode generating the arc plasma, so that the lifetime of the anode and cathode can be improved.

In an embodiment of the present invention, ammonium chloride is formed by the following reaction formula 1 due to the exhaust gas,

[reaction formula 1] 6TiCl₄ + 8NH₃ - 6TiN + N₂ +24HCl + NH₄Cl

In the processing chamber, generation of solid ammonium chloride salt may be suppressed by reaction formula 2 and reaction formula 3 below.

[reaction formula 2] TiCl₄ + N₂ + HCl + NH₃ + NF₃ → TiN + TiₓF_{y} + NF₃ + HF + HCl + Ti₃N₄ + NH₄F

[reaction formula 3] NH₄Cl + NF₃ → NH₄F + Cl₂ + HCl

In an embodiment of the present invention, the controller for adjusting the supply amount and components of the decomposition gas by controlling the N₂ plasma supply amount and the NF₃ supply amount may be further included.

### [Advantageous Effects]

According to the present invention, the generation of ammonium chloride salt is suppressed by the decomposition gas, and productivity is improved due to a decrease in the number of vacuum pump malfunction and a decrease in stop loss. In addition, it is possible to extend the PM (Preventive Maintenance) cycle.

In addition, the exterior portion and the differential pressure centering structure in the gas supplying unit make the components of the decomposition gas more uniform.

In addition, it is possible to overcome the limitations of the capacity of the conventional microwave, ICP or RF method by the exhaust gas treatment apparatus of the present invention. The conventional arts have disadvantages such as increases of capacity, energy and operating cost due to an increase of gas consumption in recent nano processes. However, according to the exhaust gas treatment apparatus of the present invention, the amount of the processing gas used is controlled by easily adjusting the supply amount of the decomposition gas.

In addition, a method of supplying NF₃ gas to the reaction chamber and decomposing NF₃ by N₂ plasma to generate decomposition gas is used instead of directly injecting NF₃ gas to the electrode of the plasma generating unit. Therefore, it is possible to solve the problem of an electrode lifetime generated when NF₃ is directly sprayed to the electrode, and to extend the lifetime of the electrode of the plasma generating unit. Of course, a material with strong corrosion resistance may be employed for the reaction chamber.

It should be understood that the effects of the present invention are not limited to the above-described effects, and include all effects that can be inferred from the configuration of the invention described in the detailed description or claims of the present invention.

### [Description of Drawings]

FIG. 1 is view for explaining an example in which salt powder is generated due to exhaust gas in a semiconductor process.
FIG. 2 is a view showing an exhaust gas treatment apparatus for semiconductor process according to an embodiment of the present invention.
FIG. 3 is a view for explaining a process in which the exhaust gas treatment apparatus operates between semiconductor processing equipment and vacuum pump according to an embodiment of the present invention.
FIG. 4 is a view for explaining a method in which the exhaust gas treatment apparatus is connected to the exhaust gas supplied from a semiconductor process and connected to a vacuum pump.
FIG. 5 a diagram illustrating an example of a plasma generating unit and a reaction chamber of exhaust gas treatment apparatus.
FIG. 6 is a view for explaining that NF₃ is supplied to reaction chamber.
FIG. 7 is a view for explaining a connection part of exhaust gas treatment apparatus.
FIG. 8 is a diagram for explaining pressure differential centering ring in a connection part of an exhaust gas treatment apparatus.
FIG. 9 is a view for explaining a process of reducing salt powder by exhaust gas treatment apparatus according to an embodiment of the present invention.
FIGs. 10 and 11 are views showing test results of NF₃ decomposition efficiency of exhaust gas treatment apparatus according to an embodiment of the present invention.
FIGs. 12 and 13 are diagrams showing performance test results of an exhaust gas treatment apparatus according to an embodiment of the present invention.
FIG. 14 is diagram for explaining performance and effects of exhaust gas treatment apparatus according to an embodiment of the present invention.

### [Modes of the Invention]

Since the present invention may be variously changed and have various forms, specific embodiments will be exemplified in the drawings and described in detail in the text. However, it should be understood that this does not limit the present invention to a specific disclosure, and includes all modifications, equivalents and substitutes included in the spirit and the scope of the present invention. In a description of each drawing, similar reference numerals are used for similar elements.

Unless otherwise defined, all terms used herein, including technical or scientific terms, have the same meaning as generally understood by those skilled in the art. Terms such as terms defined in generally used dictionaries should be interpreted as having meanings consistent with the meanings in the context of the related art, and should not be interpreted in an idealistic or excessively formal sense unless otherwise defined in the present application.

Hereinafter, exemplary embodiments of the present invention will be described in more detail with reference to the accompanying drawings.

### Embodiment

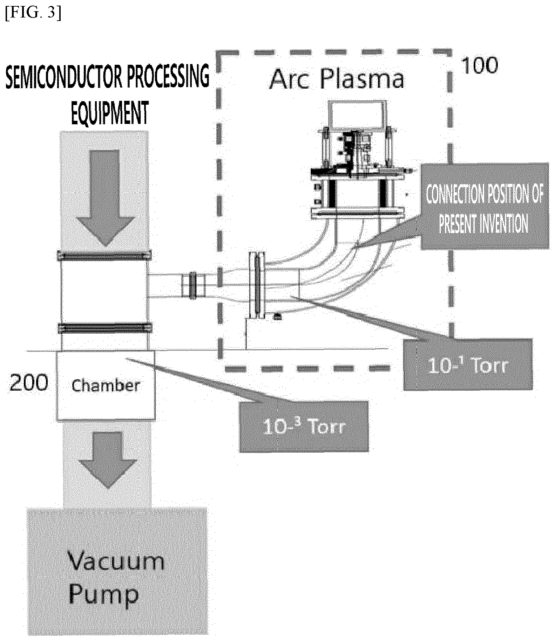

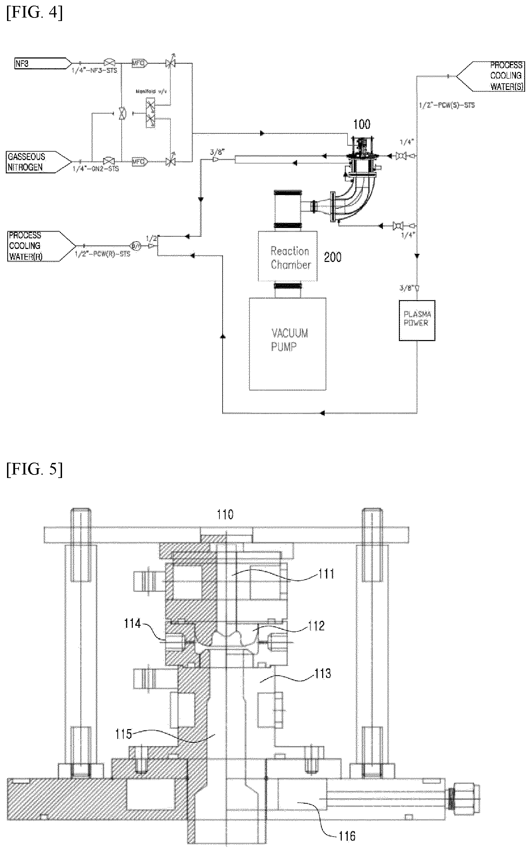

FIG. 2 is a view showing an exhaust gas treatment apparatus for semiconductor process according to an embodiment of the present invention. FIG. 3 is a view for explaining a process in which the exhaust gas treatment apparatus operates between the semiconductor processing equipment and the vacuum pump according to an embodiment of the present invention. FIG. 4 is a view for explaining a method in which the exhaust gas treatment apparatus is connected to the exhaust gas supplied from a semiconductor and connected to a vacuum pump.

Exhaust gas treatment apparatus treats exhaust gas generated from a semiconductor process and directed to a vacuum pump. The exhaust gas treatment apparatus prevents by-products generated by process gas that is discharged to vacuum pump in the semiconductor main process from flowing into the vacuum pump, so that problems in pump maintenance and facility operation are prevented. Therefore, it is possible to improve the efficiency of pump maintenance and facility operation and to improve the life (V/P Life Time) of the vacuum pump.

The exhaust gas treatment apparatus 100 has a plasma generating unit 110, reaction chamber 120 and gas supplying unit 130.

The plasma generating unit 110 has anode and cathode, and may generate an arc plasma.

In the reaction chamber 120, perfluoride may be decomposed by the plasma to generate decomposition gas.

The gas supplying unit 130 may supply the decomposition gas from the reaction chamber 120 to processing chamber 200.

The exhaust gas from the semiconductor process may be introduced into processing chamber 200, and the exhaust gas treated in the processing chamber may be discharged to the vacuum pump.

The decomposition gas supplied from the gas supplying unit 130 to the processing chamber 200 may react with the exhaust gas in the processing chamber 200 to suppress generation of salt in a solid state by components of the exhaust gas.

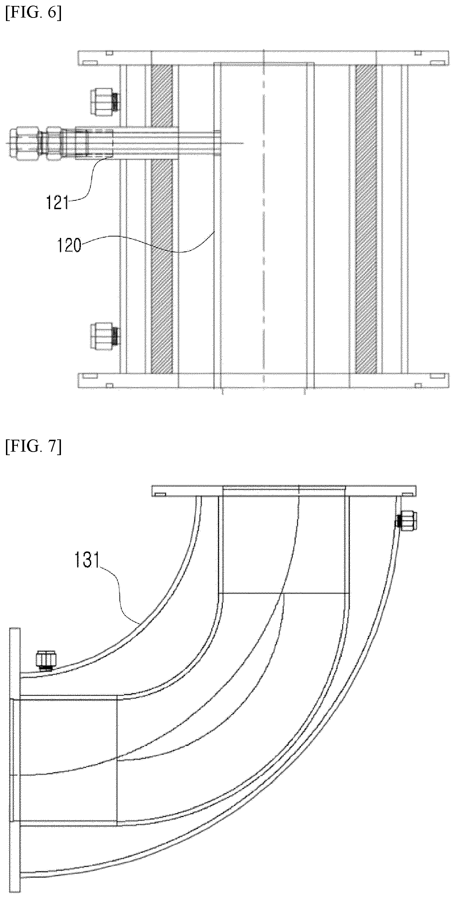

FIG. 5 is a view illustrating an example of the plasma generating unit 110 and the reaction chamber 120 of the exhaust gas treatment apparatus. FIG. 6 is a view for explaining that NF3 is supplied to the reaction chamber 120.

For example, the plasma generating unit 110 may generate N₂ plasma by arc plasma. The plasma generating unit 110 may have electrode cooling PCW unit 111, cathode 112, anode 113, N2 supplying unit 114, plasma circular tube 115 and cooling PCW unit 116. The PCW is abbreviation for process cooling water and refers to a cooling operation through water. However, the cooling operation does not necessarily use water, and any liquid capable of performing the cooling operation may be used.

When N₂ gas in introduced through the N₂ supplying unit 114, N2 plama is generated between the cathode 112 and the anode 113 according to arc discharge of the cathode 112 and the anode 113. The generated N₂ plasma is discharged through the plasma circular tube 115. The electrode cooling PCW unit 111 prevents overheating of the cathode 112 or the anode 113, and performs cooling operation. Furthermore, the cooling PCW unit 116 prevents heat having high temperature in the plasma generating unit 110 from being transferred into reaction chamber 120 and inhibiting the decomposition operation of the gas.

The perfluoride NF₃ supplied to the reaction chamber 120 may be decomposed by the N₂ plasma to generate a decomposition gas having N₂, NF₃ or F⁻. That is, F radical may be generated by decomposition of NF₃ gas due to plasma.

NF₃ gas is not directly injected into torch, but is introduced into the reaction chamber 120 connected to the plasma generating unit 110. That is, NF₃ gas is supplied to the reaction chamber 120 rather than between the anode 113 and the cathode 112 generating the arc plasma, so that the lifetime of the cathode 112 and the anode 113 may be improved.

Since the reaction chamber 120 has a double-structured chamber structure, a plasma flame is maintained at a state close to atmospheric pressure and plasma density can be secured.

The generated decomposition gas is supplied to the processing chamber as described above, and the decomposition gas reacts with NH₃ or generated NH₄Cl of the exhaust gas to generate NH₄F having gas phase, thereby suppressing the formation of NH₄Cl of solid phase.

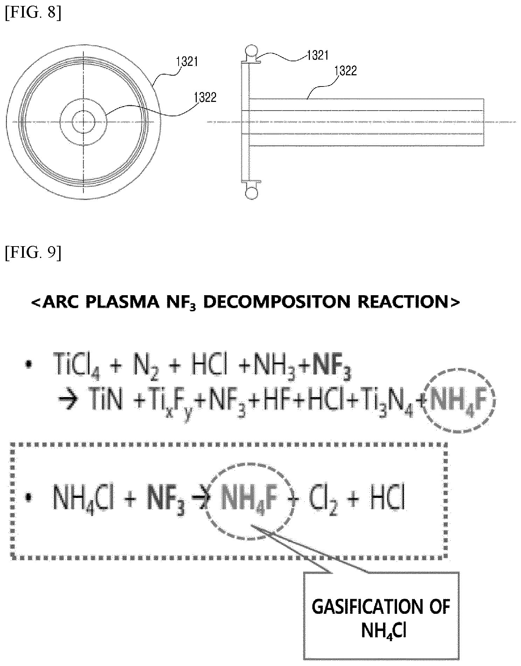

FIG. 7 is a view for explaining a connection part of an exhaust gas treatment apparatus. FIG. 8 is a view for explaining the differential pressure centering in the connection part of the exhaust gas treatment apparatus. FIG. 9 is a view for explaining a process of reducing the salt powder by the exhaust gas treatment apparatus according to an embodiment of the present invention.

The gas supplying unit 130 may have connection pipe 131 and gas injecting unit 132.

One end of the connection pipe 131 is connected to the reaction chamber 120, the decomposition gas of the reaction chamber 120 may be move through the connection pipe 131. For example, the connection pipe 131 may be a double-structured elbow part. The double-structured elbow part may have a PCW supplying structure, accordingly, the external temperature of the chamber may decrease through the inner tube cooling effect.

The gas injecting unit 132 may be provided between the connection pipe 131 and the processing chamber. The gas injecting unit 132 may inject the decomposition gas from the connection pipe 131 to the processing chamber.

For example, the gas injecting unit 132 may have differential pressure centering ring 1322 and exterior portion 1321 of which one end is coupled to the connection pipe 131. The gas injecting unit 132 may be a connection centering ring for dispersing the pressure inside the connection pipe 132.

The exterior portion 1321 may be a tube-shaped connector connecting the connection pipe 131 and the processing chamber. The exterior portion 1321 may have shape in which a diameter decreases as it approaches the processing chamber.

The differential pressure centering ring 1322 may be provided inside the exterior portion 1321 to be spaced apart from the inner surface of the exterior portion 1321. The differential pressure centering ring 1322 may have a tubular structure having a small diameter than the exterior portion 1321. The differential pressure centering ring 1322 may pass through the other end of the exterior portion 1321. The differential pressure centering ring 1322 may inject the decomposition gas into the processing chamber by a pressure difference between connection pipe 131 and the processing chamber. For example, the pressure of the connection pipe 131 may be 10⁻¹ Torr and the pressure of the processing chamber may be 10⁻³ Torr. The differential pressure centering ring 1322 may be maintained in a state close to the low pressure, which may contribute to extending the life of the torch (tungsten).

A vortex may be generated due to the space between the outer surface of the differential pressure centering ring and the inner surface of the exterior portion. Accordingly, the uniformity of the decomposition gas flowing into the gas injecting unit 132 from the connection pipe 131 may be improved and may be introduced into the inlet of the differential pressure centering ring. Accordingly, the decomposition gas with improved uniformity can be supplied to the processing chamber.

Due to the semiconductor process, ammonium may be formed as shown in Reaction Formula 1 below.

[Reaction Formula 1] 6TiCl₄ + 8NH₃ → 6TiN + N₂ + 24HCl + NH₄Cl

As described above, the ammonium chloride (NH₄Cl) may undergo a phase change from a gas phase to a solid phase depending on temperature and pressure conditions. If solid salt is generated and flows into the vacuum pump, it may cause a malfunction of the vacuum pump, and may cause the process to be interrupted, which is a great hindrance of normal operation.

The exhaust gas treatment apparatus according to the present embodiment can gasify the solid salt generated from exhaust gas of semiconductor process before being discharged to the vacuum pump. Accordingly, it is possible to prevent problems such as malfunction of the vacuum pump in advance.

Specifically, as shown in reaction formula 2 and 3 below, the formation of a solid ammonium chloride salt in the processing chamber may be suppressed.

[reaction formula 2] TiCl₄ + N₂ + NH₃ + NF₃ → TiN +TiₓF_{y} + NF₃ + HF + HCl + Ti₃N₄ + NH₄F

[reaction formula 3] NH₄Cl + NF₃ → NH₄F + Cl₂ + HCl

The decomposition gas formed by N₂ plasma may have N₂, NF₃ or F⁻. The high energy components of the decomposition gas react with ammonia of the exhaust gas to suppress the formation of ammonium chloride, or react with the already formed ammonium chloride to decompose the ammonium chloride. So, the formation of a solid ammonium chloride salt can be suppressed.

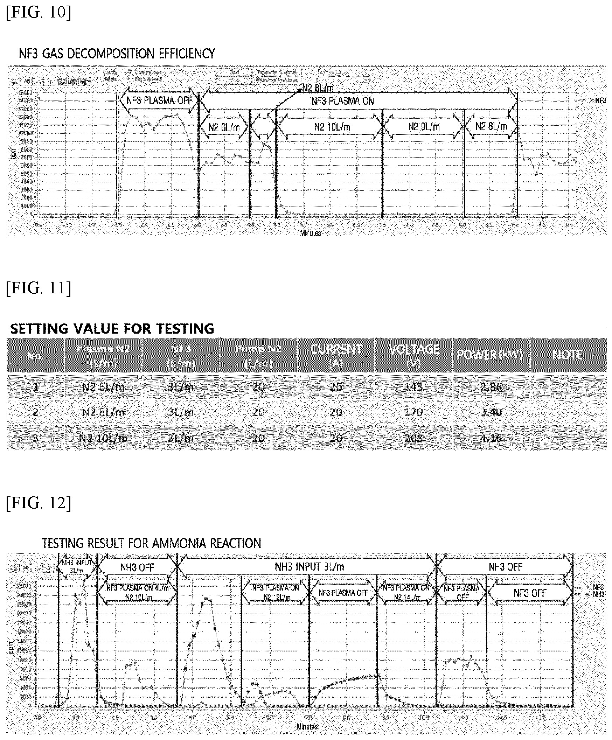

FIGs. 10 and 11 are views showing test results of NF₃ decomposition efficiency of exhaust gas treatment apparatus according to an embodiment of the present invention.

In FIG. 11, process conditions such as amount of N₂ plasma are proposed. Referring to FIGs 10 and 11, it can be seen that a large amount of NF₃ gas is detected when plasma is turned off, but when 6 L/m of N₂ plasma is supplied, NF₃ is reduced and decomposition proceeds. Thereafter, when the N₂ plasma is increased, it can be seen that the amount of NF₃ detected is very small or hardly detected, so that the decomposition is smoothly performed.

As described above, the amount and composition of the decomposition gas may be controlled by adjusting the amount of N₂ plasma, and adjusted decomposition gas may be supplied to the processing chamber. That is, the N₂, NF₃, or F⁻ component included in the decomposition gas can be controlled.

The exhaust gas treatment apparatus of the present embodiment may further include a control unit configured to control the components and supply amount of the decomposition gas by adjusting the N₂ plasma supply amount and the NF₃ supply amount.

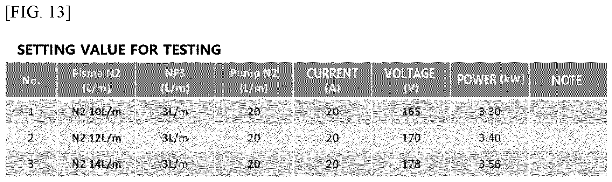

FIGs. 12 and 13 are diagrams illustrating performance test results of an exhaust gas treatment apparatus according to an embodiment of the present invention.

Referring to FIGs. 12 and 13, the results of testing the ammonia binding reaction in the processing chamber are shown.

As ammonia is introduced, the ammonia ratio is high, and as decomposition gas (NF₃ plasma) flows in, the ammonia ratio decreases and the NF₃ ratio increases. Thereafter, it can be seen that when the NF₃ plasma is repeatedly turned on, ammonia is combined and decreased, and when the NF₃ plasma is turned off, ammonia is increased.

That is, it can be confirmed that the component when the plasma is on in the decomposition gas reacts very well with the ammonia of the exhaust gas. By controlling the decomposition gas, only N₂ gas may be supplied, or NF₃ decomposed by N₂ plasma may be supplied together with N₂ gas to cause a bonding reaction with ammonia.

Accordingly, the production of ammonium chloride may be suppressed or the produced ammonium chloride may be decomposed into a gas in the form of NH₄F.

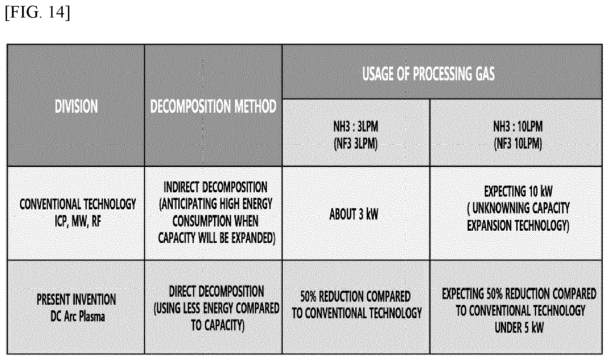

FIG. 14 is table for explaining the performance of an exhaust gas treatment apparatus according to an embodiment of the present invention.

Referring to FIG. 14, it can be seen that the exhaust gas treatment apparatus according to the present invention is superior to the conventional method and has remarkable effects.

That is, by suppressing the generation of ammonium chloride salt by decomposition gas as described above, productivity is improved by reducing the number of vacuum pump failures and reducing stop loss. Also, the PM (Preventive Maintenance) cycle can be extended.

In addition, the external portion 1321 and the differential pressure centering structure of the gas supplying unit 130 make the components of the decomposition gas more uniform and supply it to the processing chamber.

In addition, according to the exhaust gas decomposition apparatus of the present invention, it is possible to overcome the capacity limitations of conventional microwave, ICP, and RF methods. That is, the conventional technology has handicap which is an increase in capacity, energy use, and operating cost due to an increase of gas consumption in the recent nano process. However, according to the exhaust gas treatment apparatus of the present invention, the supply amount of decomposition gas is easily controlled so that it is possible to smoothly solve the increase of the amount of process gas used.

In addition, a method of supplying NF₃ to the reaction chamber 120 and decomposing NF₃ by N₂ plasma to generate decomposition gas is used instead of directly spraying NF₃ to the electrode of the plasma generating unit 110. Thus, the problem of shortening the life time of the electrodes in the plasma generating unit is resolved, and the life time of the electrodes of the plasma generating unit 110 can be extended. Of course, a material having strong corrosion resistance may be used for a reaction unit such as a reaction chamber.

The above description of the present invention is for illustration, and those of ordinary skill in the art to which the present invention pertains will understand that it can be easily modified into other specific forms without changing the subject matter or essential features of the present invention. Therefore, it should be understood that the embodiments described above are illustrative in all respects and not restrictive. For example, each component described as a single type may be implemented in a dispersed form, and likewise components described as distributed may be implemented in a combined form.

The scope of the present invention is indicated by the following claims, and all changes or modifications derived from the meaning and scope of the claims and equivalent concepts should be interpreted as being included in the scope of the present invention.

## Claims

1. An exhaust gas treatment apparatus for processing an exhaust gas generated from a semiconductor process and directed to a vacuum pump, the apparatus comprising:
a plasma generating unit for generating plasma;
a reaction chamber in which perfluoride is decomposed by the plasma to generate decomposition gas; and
a gas supplying unit for supplying the decomposition gas from the reaction chamber to a processing chamber in which the exhaust gas from the semiconductor process is introduced and treated exhaust gas is discharged to the vacuum pump,
wherein the decomposition gas reacts with the exhaust gas in the processing chamber to suppress generation of salt in solid state by a component of the exhaust gas.

2. The apparatus of claim 1, wherein the plasma generating unit generates N₂ plasma by arc plasma,
wherein NF₃ as the perfluoride supplied too the reaction chamber is decomposed by the N₂ plasma to generate the decomposition gas containing N₂, NF₃ or F⁻,
wherein the decomposition gas supplied to the processing chamber reacts with NH₃ of the exhaust gas or generated NH₄Cl to form gaseous NH₄F so that forming of solid NH₄Cl is suppressed.

3. The apparatus of claim 2, wherein the gas supplying unit comprises,
a connection pipe through which the decomposition gas from the reaction chamber is moved; and
a gas injecting unit disposed between the connection pipe and the processing chamber, and injecting the decomposition gas into the processing chamber.

4. The apparatus of claim 3, wherein the gas injection unit includes,
an exterior portion having one end coupled to the connection pipe; and
a differential pressure centering ring coupled to the other end of the exterior portion, provided inside the connection pipe and spaced apart from an inner surface of the connection pipe, and injecting the decomposition gas into the processing chamber by a pressure difference between the connection pipe and the processing chamber.

5. The apparatus of claim 4, wherein the decomposition gas has uniformity by vortex caused by a space between the differential pressure centering ring and the inner surface of the connection pipe, and flows into the differential pressure centering ring.

6. The apparatus of claim 3, wherein the NF₃ gas is supplied to the reaction chamber rather than between anode and cathode generating the arc plasma, so that the lifetime of the anode and the cathode is improved.

7. The apparatus of claim 2, wherein the exhaust gas forms ammonium chloride salt due to Reaction Formula 1, and the generation of the ammonium chloride salt in solid state is suppressed due to Reaction Formula 2 and Reaction Formula 3 in the processing chamber.
[Reaction Formula 1] 3TiCl₄ + 8NH₃ → 3TiN +1/2N₂ + 8HCl + 4NH₄Cl
[Reaction Formula 2] TiCl₄ + N₂ + NH₃ + NF₃ → TiN +TiₓF_{y} + NF₃ + HF + HCl + Ti₃N₄ + NH₄F
[Reaction Formula 3] NH₄Cl + NF₃ → NH₄F + Cl₂ + HCl

8. The apparatus of claim 3, further comprises control unit for controlling a supply amount and component of the decomposition gas by controlling supply amount of the N₂ plasma and supply amount of the NF₃ gas.
